(19) **Europäisches Patentamt / European Patent Office / Office européen des brevets**

(11) **EP 4 481 404 B1**

(12) **FASCICULE DE BREVET EUROPEEN**

(45) Date de publication et mention
de la délivrance du brevet:
**10.09.2025 Bulletin 2025/37**

(21) Numéro de dépôt: **24181771.7**

(22) Date de dépôt: **12.06.2024**

(51) Classification Internationale des Brevets (IPC):
***G01R 22/10*** *(2006.01)*

(52) Classification Coopérative des Brevets (CPC):
**G01R 22/10**

(54) **PROCEDE POUR ETABLIR UNE CONSOMMATION ELECTRIQUE D'UNE INSTALLATION ELECTRIQUE**

VERFAHREN ZUM ERMITTELN EINES ELEKTRISCHEN VERBRAUCHS EINER ELEKTRISCHEN ANLAGE

METHOD FOR ESTABLISHING AN ELECTRICAL CONSUMPTION OF AN ELECTRICAL INSTALLATION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.06.2023 FR 2306043**

(43) Date de publication de la demande:
**25.12.2024 Bulletin 2024/52**

(73) Titulaire: **SAGEMCOM ENERGY & TELECOM SAS 92270 Bois-Colombes (FR)**

(72) Inventeurs:
- **TEBOULLE, Henri**
  **92270 Bois-Colombes (FR)**
- **LEBAILLY, Lucas**
  **92270 Bois-Colombes (FR)**
- **MAGOT, Clément**
  **92270 Bois-Colombes (FR)**

(74) Mandataire: **Cabinet Le Guen Maillet
3, impasse de la Vigie
CS 71840
35418 Saint-Malo Cedex (FR)**

(56) Documents cités:
**US-A1- 2003 088 374    US-A1- 2022 413 023**

**Description**

DOMAINE TECHNIQUE

La présente invention concerne un ajustement de mesures par un compteur électrique afin de prendre en compte des imprécisions de caractéristiques de composants du compteur électrique qui sont utilisés pour effectuer des mesures de tension et de courant servant à établir une consommation électrique d'une installation électrique supervisée par le compteur électrique.

ETAT DE LA TECHNIQUE ANTERIEURE

Afin d'établir la consommation électrique d'une installation électrique, un compteur électrique effectue des calculs de puissance en utilisant des échantillons de mesures de tension et courant alternatifs en entrée de l'installation électrique. Les mesures de tension et courant alternatifs sont réalisées grâce à des composants électroniques : les mesures de tension sont typiquement réalisées grâce à des ponts diviseurs de tensions ; en monophasé, les mesures de courant sont typiquement réalisées grâce à des shunts de mesure ; en polyphasé (e.g., triphasé), les mesures de courant sont typiquement réalisées grâce à des tores.

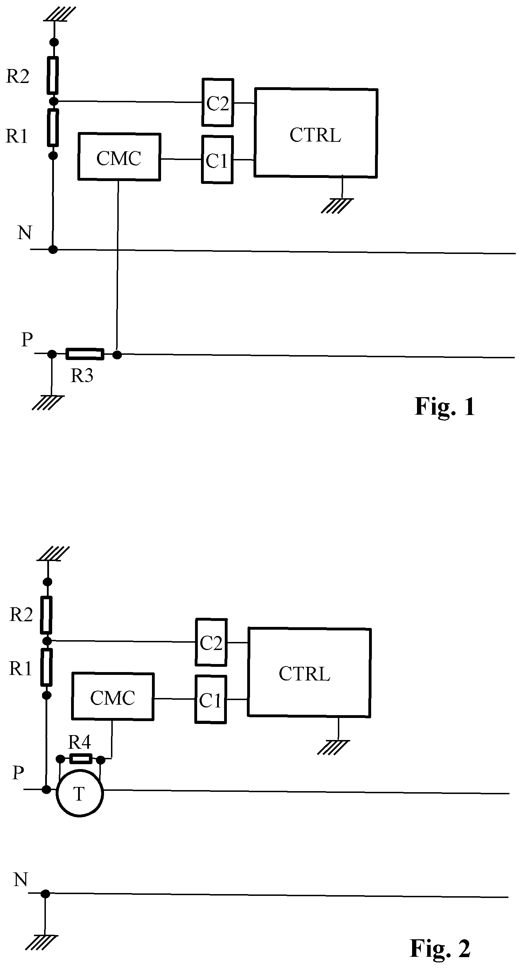

La Fig. 1 illustre schématiquement un agencement pour obtenir des échantillons de mesure de tension et courant alternatifs, entre une ligne de phase P et une ligne de neutre N, dans un compteur électrique monophasé.

Un pont diviseur de tension est réalisé grâce à des résistances R1 et R2 entre la ligne de neutre N et la masse. Un convertisseur analogique numérique C2 placé à un point de jonction des résistances R1 et R2 permet d'obtenir des échantillons de mesures de tension.

Un shunt, réalisé par une résistance calibrée R3, est placé sur la ligne de phase P. La ligne de phase P est ici reliée à la masse. Une chaîne de mesure de courant CMC couplée à un convertisseur analogique numérique C1 permet d'obtenir des échantillons de mesures de courant.

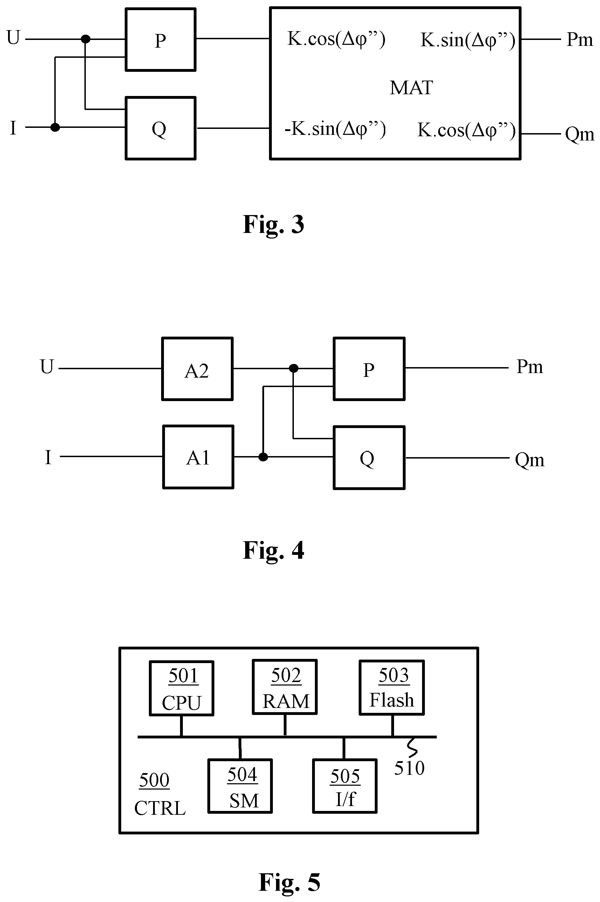

Le compteur électrique comporte un contrôleur CTRL configuré pour établir une consommation électrique à partir de calculs de puissance effectués à partir des échantillons de mesure de tension et courant alternatifs obtenus, comme décrit ci-après en relation avec la Fig. 3.

La Fig. 2 illustre schématiquement un agencement pour obtenir des échantillons de mesure de tension et courant alternatifs, entre une ligne de phase P et une ligne de neutre N, dans un compteur électrique polyphasé (e.g., triphasé). La ligne de neutre N est ici reliée à la masse.

Un pont diviseur de tension est réalisé grâce à des résistances R1 et R2 entre la ligne de phase P en question et la masse. Un convertisseur analogique numérique C2 placé à un point de jonction des résistances R1 et R2 permet d'obtenir des échantillons de mesures de tension.

Un tore T est placé sur la ligne de phase P, avec une résistance R4 en parallèle. Une chaîne de mesure de courant CMC couplée à un convertisseur analogique numérique C1 permet d'obtenir des échantillons de mesures de courant.

L'agencement de la Fig. 2 est répliqué pour chaque phase, le contrôleur CTRL étant toutefois ici commun aux différentes phases. Le contrôleur CTRL est ainsi configuré pour établir une consommation électrique à partir de calculs de puissance effectués à partir des échantillons de mesure de tension et courant alternatifs obtenus pour chacune des phases.

Les caractéristiques réelles des shunts, tores et résistances sont spécifiques à chaque compteur électrique. A titre d'exemple, la précision d'un shunt est donnée à $\pm 5\%$, celle des résistances de $\pm 1\%$ et un tore peut déphaser le signal de courant de plusieurs degrés. Il est alors usuel d'ajuster les résultats des calculs de puissance pour compenser un écart de précision effective de caractéristiques des composants électroniques utilisés pour réaliser les mesures de tension et courant alternatifs.

Ainsi, comme illustré sur la Fig. 3, le contrôleur CTRL réalise par exemple un calcul de puissance active P et un calcul de puissance réactive Q, à partir des échantillons de mesures de tension U et de courant I obtenus. Le déphasage et le gain dus au tore pour chaque phase en polyphasé (e.g., triphasé), ou au shunt en monophasé, sont compensés en ajustant les puissances P et Q à l'aide d'un calcul matriciel MAT afin d'obtenir une puissance active corrigée Pm et une puissance réactive corrigée Qm. Le calcul matriciel MAT inclut respectivement une compensation en phase $\Delta\varphi$ prédéfinie et une compensation en amplitude K prédéfinie.

Etant donné que les calculs de puissance sont des calculs complexes intégrant une somme multiple de multiplications d'échantillons de tension et de courant, une compensation en phase $\Delta\varphi$ '' et en amplitude $K$ au niveau de ces calculs de puissance entraîne une imprécision résiduelle. Cette imprécision résiduelle est d'autant plus importante en polyphasé (e.g., triphasé) du fait que les déphasages notamment liés aux tores sont différents d'une phase à l'autre.

Le document US 2003/0088374 A1 traite de calibration / d'étalonnage dans un compteur électrique pour corriger des erreurs de mesures de capteurs de courant et de tension pour le calcul de consommation d'énergie.

Le document US 2022/413023 A1 traite de correction d'erreurs de mesures liées à une fraude dans un compteur électrique triphasé.

Il est alors souhaitable de pallier ces inconvénients de l'état de la technique.

EXPOSE DE L'INVENTION

Il est proposé ici un procédé selon la revendication 1 pour établir une consommation électrique d'une installation électrique qui est alimentée électriquement par au moins une phase et qui est supervisée par un compteur électrique, le procédé étant implémenté par un contrôleur du compteur électrique et comportant : obtenir, pour chaque phase, des échantillons de mesures de tension et des échantillons de mesures de courant ; appliquer un ajustement en amplitude $K_U$ et un ajustement en phase $\Delta\varphi$ sur les échantillons de mesure de tension pour obtenir des échantillons de tension ajustés ; appliquer un ajustement en amplitude $K_I$ et un ajustement en phase $\Delta\varphi'$ sur les échantillons de mesure de courant pour obtenir des échantillons de courant ajustés ; effectuer au moins un calcul de puissance à partir des échantillons de de tension et de courant ajustés ; et établir la consommation électrique à partir dudit au moins un calcul de puissance. De plus, pour obtenir les échantillons de courant ajustés, le procédé comporte en outre : appliquer un ajustement complémentaire $K'_I$ aux échantillons de mesure de courant pour compenser un étalement d'échantillons de mesure de tension sur les échantillons de mesure de courant.

Ainsi, en appliquant l'ajustement en amplitude et en phase sur les échantillons de mesures plutôt que sur ledit au moins un calcul de puissance, une meilleure précision de métrologie est obtenue. De plus, étalement d'échantillons de mesure de tension sur les échantillons de mesure de courant est compensé, ce qui augmente la précision.

Selon un mode de réalisation particulier, l'ajustement en phase $\Delta\varphi$ est appliqué par interpolation, où entre deux échantillons de mesure de tension successifs $U_{n-1}$ et $U_n$ à des instants respectifs $t_{n-1} = (n\text{-}1) \times T_E$ et $t_n = n \times T_E$ suivant une période d'échantillonnage $T_E$, l'interpolation fournit un échantillon $U_{n-1+r}$ à un instant d'échantillonnage fictif $t_{n-1+r} = (n\text{-}1+r) \times T_E$, avec $r$ tel que $\Delta\varphi = 2\pi r$, et l'ajustement en phase $\Delta\varphi'$ est appliqué par interpolation, où entre deux échantillons de mesure de courant successifs $I_{n-1}$ et $I_n$ aux instants respectifs $t_{n-1} = (n\text{-}1) \times T_E$ et $t_n = n \times T_E$, l'interpolation fournit un échantillon $I_{n-1+r'}$ à un instant d'échantillonnage fictif $t_{n-1+r'} = (n\text{-}1+r') \times T_E$, avec $r'$ tel que $\Delta\varphi' = 2\pi r'$.

Selon un mode de réalisation particulier, l'interpolation est linéaire, où l'interpolation linaire fournit des échantillons de tension interpolés $U_{n-1+r}$ et de courant interpolés $I_{n-1+r'}$ tels que :

$$U_{n\text{-}1+r} = (1 + K_U) \times (r \times U_n + (1\text{-}r) \times U_{n\text{-}1})$$

et

$$I_{n\text{-}1+r'} = (1 + K_I) \times (r' \times I_n + (1\text{-}r') \times I_{n\text{-}1}) + K'_I \times U_{n\text{-}1+r}.$$

Selon un mode de réalisation particulier, l'installation électrique qui est supervisée par le compteur électrique est alimentée en triphasé. Ainsi, l'ajustement en amplitude et en phase sur les échantillons de mesures est encore plus précis que ne le serait un ajustement en amplitude et en phase sur ledit au moins un calcul de puissance (du fait particulièrement de déphasages distincts introduits par des tores utilisés sur les phases pour réaliser la mesure de courant).

Selon un mode de réalisation particulier, ledit au moins un calcul de puissance est un calcul de puissance active et/ou de puissance réactive et/ou de puissance apparente.

Il est aussi proposé ici un programme d'ordinateur comportant des instructions de code de programme causant une implémentation du procédé, lorsque lesdites instructions sont exécutées par un processeur de compteur intelligent.

Il est aussi proposé ici un support de stockage d'informations stockant de telles instructions de code de programme.

Il est aussi proposé ici un contrôleur de compteur électrique, qui est configuré pour établir une consommation électrique d'une installation électrique qui est alimentée électriquement par au moins une phase et qui est supervisée par le compteur électrique, ledit contrôleur comportant de la circuiterie électronique configurée pour : obtenir, pour chaque phase, des échantillons de mesures de tension et des échantillons de mesures de courant ; appliquer un ajustement en amplitude $K_U$ et un ajustement en phase $\Delta\varphi$ sur les échantillons de mesure de tension pour obtenir des échantillons de tension ajustés ; appliquer un ajustement en amplitude $K_I$ et un ajustement en phase $\Delta\varphi'$ sur les échantillons de mesure de courant pour obtenir des échantillons de courant ajustés ; effectuer au moins un calcul de puissance à partir des échantillons de tension et de courant ajustés ; et établir la consommation électrique à partir dudit au moins un calcul de puissance. De plus, pour obtenir les échantillons de courant ajustés, le procédé comporte en outre : appliquer un ajustement complémentaire $K'_I$ aux échantillons de mesure de courant pour compenser un étalement d'échantillons de mesure de tension sur les échantillons de mesure de courant.

Il est aussi proposé ici un compteur électrique équipé du contrôleur ci-dessus.

BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :

[Fig. 1] illustre schématiquement un agencement pour obtenir des échantillons de mesure de tension et de courant dans un compteur électrique monophasé ;

[Fig. 2] illustre schématiquement un agencement pour obtenir des échantillons de mesure de tension et de courant par phase dans un compteur électrique polyphasé ;

[Fig. 3] illustre schématiquement un agencement pour effectuer un calcul de puissance pour établir une consommation électrique, selon l'état de la technique ;

[Fig. 4] illustre schématiquement un agencement pour effectuer un calcul de puissance pour établir une consommation électrique, selon un mode de réalisation de la présente invention ;

[Fig. 5] illustre schématiquement un exemple d'agencement matériel d'un contrôleur de compteur électrique ;

[Fig. 6] illustre schématiquement un algorithme pour effectuer un calcul de puissance pour établir une consommation électrique, selon un mode de réalisation de la présente invention ; et

[Fig. 7] illustre schématiquement un exemple d'interpolation linéaire utilisée pour ajuster en phase des échantillons, selon un mode de réalisation de la présente invention.

EXPOSE DETAILLE DE MODES DE REALISATION

La Fig. 4 illustre schématiquement un agencement pour effectuer un calcul de puissance pour établir une consommation électrique, selon un mode de réalisation de la présente invention. Le calcul de puissance est réalisé pour établir une consommation électrique d'une installation électrique qui est alimentée électriquement par au moins une phase et qui est supervisée par un compteur électrique. La Fig. 4 s'appuie sur l'agencement de la Fig. 1 ou celui de la Fig. 2 pour obtenir des échantillons de mesures de tension et de courant.

La Fig. 4 inclut un calcul de puissance active P et un calcul de puissance réactive Q. Mais au lieu de baser ces calculs de puissance sur les échantillons de mesures de tension U et de courant I bruts comme dans le cadre de la Fig. 3, les calculs de puissance active P et de puissance réactive Q utilisent des échantillons de tension et de courant ajustés en amplitude et en phase. Ainsi, les échantillons de mesures de tension U fournis par le convertisseur analogique-numérique C2 subissent un ajustement A2 en amplitude (gain $K_U$) et en phase $\Delta\varphi$, et les échantillons de mesures de courant I fournis par le convertisseur analogique-numérique C1 subissent un ajustement A1 en amplitude (gain $K_I$) et en phase $\Delta\varphi'$ (ajustement typiquement différent que pour les échantillons de mesures de tension U).

En obtenant la puissance active corrigée Pm et la puissance réactive corrigée Qm en effectuant les calculs de puissance active P et de puissance réactive Q à partir d'échantillons de tension et de courant ajustés en amplitude et en phase, plutôt que d'effectuer une compensation d'amplitude et de phase après les calculs de puissance active P et de puissance réactive Q, la précision de mesure de consommation électrique est améliorée.

La Fig. 5 illustre schématiquement un exemple d'agencement matériel du contrôleur CTRL qui est adapté aux calculs de puissance et de consommation électrique selon la présente invention.

La contrôleur CTRL 500 comporte, reliés par un bus de communication 510 : un processeur ou CPU (« Central Processing Unit » en anglais) 501 ; une mémoire vive RAM (« Random-Access Memory » en anglais) 502 ; une mémoire morte 503, par exemple de type ROM (« Read Only Memory » en anglais) ou EEPROM (« Electrically-Erasable Programmable ROM » en anglais), telle qu'une mémoire Flash ; un support de stockage SM 504, tel qu'un disque dur HDD (« Hard Disk Drive » en anglais) ou un lecteur de cartes SD (« Secure Digital » en anglais) ; et un gestionnaire d'interfaces I/f 505.

Le gestionnaire d'interfaces I/f 505 permet au contrôleur CTRL 505 d'interagir avec d'autres équipements du compteur électrique, comme par exemple un émetteur récepteur lorsque le compteur électrique est un compteur communicant. Le gestionnaire d'interfaces I/f 505 permet au contrôleur CTRL 500 de recevoir les échantillons de mesures de tension U et I en provenance des convertisseurs analogiques-numériques. En variante de réalisation, les convertisseurs analogiques-numériques sont inclus dans le contrôleur CTRL 500, par exemple dans le gestionnaire d'interfaces I/f 505.

Le processeur 501 est capable d'exécuter des instructions chargées dans la mémoire vive 502 à partir de la mémoire morte 503, d'une mémoire externe, d'un support de stockage (tel qu'une carte SD), ou d'un réseau de communication. Lorsque le contrôleur CTRL 500 est mis sous tension, le processeur 501 est capable de lire de la mémoire vive 502 des instructions et de les exécuter. Ces instructions forment un programme d'ordinateur causant l'implémentation, par le processeur 501, de tout ou partie des étapes, procédés et fonctionnements décrits ici.

Tout ou partie des étapes, procédés et fonctionnements décrits ici peut ainsi être implémenté sous forme logicielle par exécution d'un ensemble d'instructions par une machine programmable, par exemple un processeur de type DSP (« Digital Signal Processor » en anglais) ou un microcontrôleur, ou être implémenté sous forme matérielle par une machine ou un composant électronique (« chip » en anglais) dédié ou un ensemble de composants électroniques (« chipset » en anglais) dédié, par exemple un composant FPGA (« Field Programmable Gate Array » en anglais) ou ASIC (« Application Specific Integrated Circuit » en anglais). D'une manière générale, le contrôleur CTRL 500 (et donc le compteur électrique) comporte de la circuiterie électronique adaptée et configurée pour implémenter les fonctionnements, procédés et étapes décrits ici.

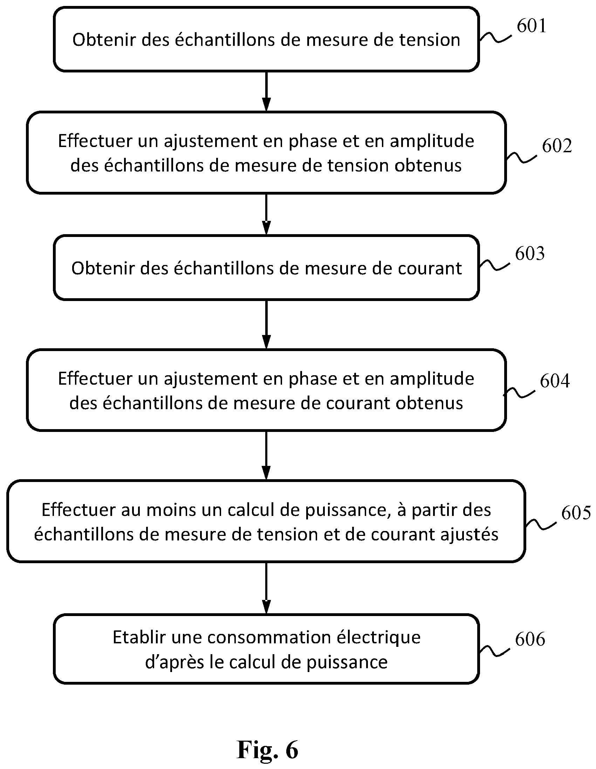

La Fig. 6 illustre schématiquement un algorithme pour effectuer un calcul de puissance pour établir une consommation électrique, selon un mode de réalisation de la présente invention.

Dans une étape 601, le contrôleur CTRL obtient des échantillons de mesure de tension.

Dans une étape 602, le contrôleur CTRL effectue un ajustement en phase $\Delta\varphi$ et en amplitude $K_U$ des échantillons de mesure de tension obtenus afin d'obtenir des échantillons de tension ajustés.

Les étapes 601 et 602 sont effectuées pour chaque phase (*i.e.,* pour chacune des trois phases en triphasé).

Dans une étape 603, le contrôleur CTRL obtient des échantillons de mesure de courant.

Dans une étape 604, le contrôleur CTRL effectue un ajustement en phase $\Delta\varphi'$ et en amplitude $K_I$ des échantillons de mesure de courant obtenus afin d'obtenir des échantillons de courant ajustés.

Les étapes 603 et 604 sont effectuées pour chaque phase (*i.e.,* pour chacune des trois phases en triphasé).

Dans un mode de réalisation particulier, le contrôleur CTRL obtient un échantillon de tension ajusté en phase $U_{n-1+r}$ par interpolation entre l'échantillon de mesure de tension obtenu $U_{n-1}$ et l'échantillon de mesure de tension obtenu $U_n$, en définissant $r$ tel que $\Delta\varphi=2\pi r$, puis par application de l'ajustement en amplitude $K_U$. Et de manière analogue, le contrôleur CTRL obtient un échantillon de courant ajusté en phase $I_{n-1+r'}$ par interpolation entre l'échantillon de mesure de courant obtenu $I_{n-1}$ et l'échantillon de mesure de courant obtenu $I_n$, puis par application de l'ajustement en amplitude $K_I$ (en définissant $r'$ tel que $\Delta\varphi'=2\pi r'$).

L'interpolation peut être quadratique, cubique ou spline.

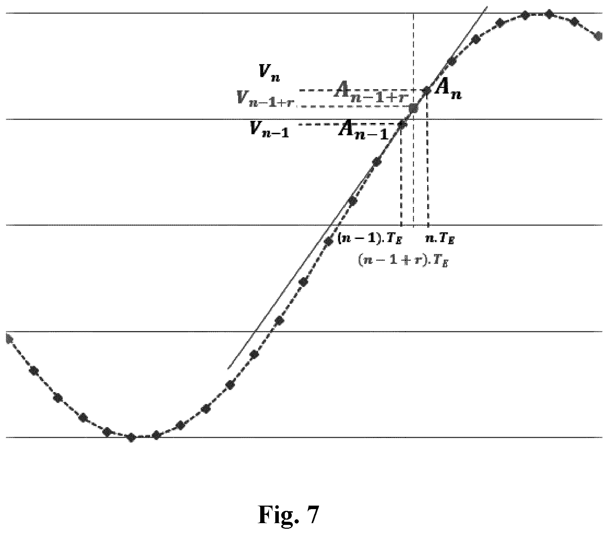

Dans un mode de réalisation particulier, l'interpolation est linéaire, comme schématiquement illustré sur la Fig. 7. La Fig. 7 comporte des points, sur une courbe sinusoïdale, qui représentent des échantillons de mesures (de tension ou de courant) tels que fournis par un dit convertisseur analogique-numérique. En abscisses est représenté le temps et en ordonnées sont représentées les valeurs des échantillons de mesures.

Les échantillons correspondent à des mesures effectuées (fournis par les convertisseurs analogiques-numériques) selon une période d'échantillonnage $T_E$, par exemple égale à 384.62 µs, correspondant donc à une fréquence d'échantillonnage $f_E$ de 2600 Hz. Les points $A_{n-1}$ et $A_n$ correspondent à des échantillons de mesures successifs, à des instants de mesure respectifs $t_{n-1} = (n-1) \times T_E$ et $t_n = n \times T_E$, et ont pour valeurs de mesures respectives $V_{n-1}$ et $V_n$. Le point $A_{n-1+r}$ est un point interpolé à un instant de mesure fictif $t_{n-1+r} = (n-1+r) \times T_E$, avec une valeur d'amplitude interpolée $V_{n-1+r}$. Alors : $V_{n-1+r} = r \times V_n + (1-r) \times V_{n-1}$. L'interpolation linéaire est avantageusement simple en calculs et nécessite peu de ressources.

Ainsi, pour chaque phase :

$$U_{n-1+r} = (1 + K_U) \times (r \times U_n + (1-r) \times U_{n-1})$$

$$I_{n-1+r'} = (1 + K_I) \times (r' \times I_n + (1-r') \times I_{n-1})$$

$K_U$, $K_I$, $r$ et $r'$ sont des constantes spécifiques à chaque compteur électrique et à chaque phase. $K_U$, $K_I$, $r$ et $r'$ sont calibrés en usine à l'aide de mesures dont on connaît le résultat attendu et vers lequel on doit tendre. Ceci consiste à résoudre un système d'équations multiples à plusieurs inconnues.

De plus, le contrôleur CTRL effectue un ajustement complémentaire des échantillons de mesure de courant pour compenser un étalement des échantillonnages en tension sur les échantillonnages en courant. Un tel étalement a été constaté sur certains convertisseurs analogiques- numériques qui fournissent les échantillons de tension et de courants sous forme de voies multiplexées. Le contrôleur CTRL applique alors un gain $K'_I$ sur l'échantillon de tension (ajusté) correspondant $U_{n-1+r}$ pour la phase concernée. Alors, dans le cas de l'interpolation linéaire exposée ci-dessus, les échantillons de courant sont ajustés, pour chaque phase, de la façon suivante :

$$I_{n-1+r'} = (1 + K_I) \times (r' \times I_n + (1-r') \times I_{n-1}) + K'_I \times U_{n-1+r}$$

Dans ce cas, $K_U$, $K_I$, $K'_I$, $r$ et $r'$ sont calibrés en usine à l'aide de mesures dont on connaît le résultat attendu et vers lequel on doit tendre. Ceci consiste à résoudre un autre système d'équations multiples à plusieurs inconnues.

Dans une étape 605, le contrôleur CTRL effectue au moins un calcul de puissance à partir des échantillons de tension et de courant ajustés ($U_{n-1+r}$ et $I_{n-1+r'}$) pour chaque phase.

Le calcul de puissance peut être un calcul de puissance active et/ou de puissance réactive et/ou de puissance apparente.

Dans l'étape 606, le contrôleur CTRL établit une consommation électrique, de l'installation électrique, d'après ledit au moins un calcul de puissance de l'étape 605.

Il convient de noter que, en considérant un compteur électrique en triphasé qui comporte 3 tores T1, T2 et T3, où le tore T1 déphase de $\Delta\varphi_1$ (par exemple, +1.5°), le tore T2 déphase de $\Delta\varphi_2$ (par exemple, -0.7°) et le tore T3 déphase de $\Delta\varphi_3$ (par exemple, -1°), il est impossible de choisir un instant d'échantillonnage qui permette de compenser ces 3 déphasages simultanément (dès lors que ces déphasages sont de valeurs différentes). Il ressort donc clairement qu'il est préférable d'interpoler les échantillons U et I comme proposé dans la solution plutôt que de corriger des déphasages en jouant sur l'instant d'échantillonnage.

**Revendications**

1.  Procédé pour établir une consommation électrique d'une installation électrique qui est alimentée électriquement par au moins une phase et qui est supervisée par un compteur électrique, le procédé étant implémenté par un contrôleur (500) du compteur électrique et comportant :

    - obtenir (601, 603), pour chaque phase, des échantillons de mesures de tension et des échantillons de mesures de courant ;
    - appliquer (602) un ajustement en amplitude $K_U$ et un ajustement en phase $\Delta\varphi$ sur les échantillons de mesure de tension pour obtenir des échantillons de tension ajustés ;
    - appliquer (604) un ajustement en amplitude $K_I$ et un ajustement en phase $\Delta\varphi'$ sur les échantillons de mesure de courant pour obtenir des échantillons de courant ajustés ;
    - effectuer (605) au moins un calcul de puissance à partir des échantillons de tension et de courant ajustés ; et
    - établir (606) la consommation électrique à partir dudit au moins un calcul de puissance, **caractérisé en ce que** le procédé comporte en outre, pour obtenir les échantillons de courant ajustés :

        - appliquer un ajustement complémentaire aux échantillons de mesure de courant pour compenser un étalement d'échantillons de mesure de tension sur les échantillons de mesure de courant, l'ajustement complémentaire étant une application de gain $K'_I$ sur desdits échantillons de tension ajustés correspondants.

2.  Procédé selon la revendication 1, dans lequel l'ajustement en phase $\Delta\varphi$ est appliqué par interpolation, où entre deux échantillons de mesure de tension successifs $U_{n-1}$ et $U_n$ à des instants respectifs $t_{n-1} = (n-1) \times T_E$ et $t_n = n \times T_E$ suivant une période d'échantillonnage $T_E$, l'interpolation fournit un échantillon $U_{n-1+r}$ à un instant d'échantillonnage fictif $t_{n-1+r} = (n-1+r) \times T_E$, avec $r$ tel que $\Delta\varphi = 2\pi r$, et l'ajustement en phase $\Delta\varphi'$ est appliqué par interpolation, où entre deux échantillons de mesure de courant successifs $I_{n-1}$ et $I_n$ aux instants respectifs $t_{n-1} = (n-1) \times T_E$ et $t_n = n \times T_E$, l'interpolation fournit un échantillon $I_{n-1+r'}$ à un instant d'échantillonnage fictif $t_{n-1+r'} = (n-1+r') \times T_E$, avec $r'$ tel que $\Delta\varphi' = 2\pi r'$.

3.  Procédé selon la revendication 2, dans lequel l'interpolation est linéaire, où l'interpolation linaire fournit des échantillons de tension interpolés $U_{n-1+r}$ et de courant interpolés $I_{n-1+r'}$ tels que :

$$U_{n-1+r} = (1 + K_U) \times (r \times U_n + (1-r) \times U_{n-1})$$

et

$$I_{n-1+r'} = (1 + K_I) \times (r' \times I_n + (1-r') \times I_{n-1}) + K'_I \times U_{n-1+r}.$$

4.  Procédé selon l'une quelconque des revendications 1 à 3, dans lequel l'installation électrique qui est supervisée par le compteur électrique est alimentée en triphasé.

5.  Procédé selon l'une quelconque des revendications 1 à 4, dans lequel ledit au moins un calcul de puissance est un calcul de puissance active et/ou de puissance réactive et/ou de puissance apparente.

6.  Produit programme d'ordinateur comportant des instructions de code de programme causant une implémentation du procédé selon l'une quelconque des revendications 1 à 5, lorsque lesdites instructions sont exécutées par un processeur de contrôleur (500) de compteur électrique.

7. Support de stockage d'informations stockant des instructions de code de programme entraînant une implémentation du procédé selon l'une quelconque des revendications 1 à 5, lorsque lesdites instructions sont lues et exécutées par un processeur de contrôleur (500) de compteur électrique.

8. Contrôleur (500) de compteur électrique, qui est configuré pour établir une consommation électrique d'une installation électrique qui est alimentée électriquement par au moins une phase et qui est supervisée par le compteur électrique, ledit contrôleur (500) comportant de la circuiterie électronique configurée pour :

- obtenir (601, 603), pour chaque phase, des échantillons de mesures de tension et des échantillons de mesures de courant ;
- appliquer (602) un ajustement en amplitude $K_U$ et un ajustement en phase $\Delta\varphi$ sur les échantillons de mesure de tension pour obtenir des échantillons de tension ajustés ;
- appliquer (604) un ajustement en amplitude $K_1$ et un ajustement en phase $\Delta\varphi'$ sur les échantillons de mesure de courant pour obtenir des échantillons de courant ajustés ;
- effectuer (605) au moins un calcul de puissance à partir des échantillons de tension et de courant ajustés ; et
- établir (606) la consommation électrique à partir dudit au moins un calcul de puissance, **caractérisé en ce que** la circuiterie électronique est en outre configurée pour, afin d'obtenir les échantillons de courant ajustés :

- appliquer un ajustement complémentaire aux échantillons de mesure de courant pour compenser un étalement d'échantillons de mesure de tension sur les échantillons de mesure de courant, l'ajustement complémentaire étant une application de gain $K'_I$ sur desdits échantillons de tension ajustés correspondants.

9. Compteur électrique comportant un contrôleur (500) selon la revendication 8.


**Patentansprüche**

1. Verfahren zum Ermitteln eines elektrischen Verbrauchs einer elektrischen Anlage, die durch mindestens eine Phase elektrisch versorgt wird und die von einem elektrischen Zähler überwacht wird, wobei das Verfahren von einem Controller (500) des elektrischen Zählers implementiert wird und umfasst:

- Erhalten (601, 603), für jede Phase, von Spannungsmessungsabtastwerten und von Strommessungsabtastwerten;
- Anwenden (602) einer Amplitudenanpassung $K_U$ und einer Phasenanpassung $\Delta\varphi$ auf die Spannungsmessungsabtastwerte, um angepasste Spannungsabtastwerte zu erhalten;
- Anwenden (604) einer Amplitudenanpassung $K_I$ und einer Phasenanpassung $\Delta\varphi'$ auf die Strommessungsabtastwerte, um angepasste Stromabtastwerte zu erhalten;
- Durchführen (605) mindestens einer Leistungsberechnung ausgehend von den angepassten Spannungs- und Stromabtastwerten; und
- Ermitteln (606) des elektrischen Verbrauchs ausgehend von der mindestens einen Leistungsberechnung, **dadurch gekennzeichnet, dass** das Verfahren ferner, zum Erhalten der angepassten Stromabtastwerte, umfasst:

- Anwenden einer ergänzenden Anpassung auf die Strommessungsabtastwerte, um eine Spannungsmessungsabtastwertespreizung bei den Strommessungsabtastwerten zu kompensieren, wobei die ergänzende Anpassung eine Anwendung einer Verstärkung $K'_I$ auf entsprechende angepasste Spannungsabtastwerte ist.

2. Verfahren nach Anspruch 1, wobei die Phasenanpassung $\Delta\varphi$ durch Interpolation angewandt wird, wobei die Interpolation zwischen zwei aufeinander folgenden Spannungsmessungsabtastwerten $U_{n-1}$ und $U_n$ zu jeweiligen Zeitpunkten $t_{n-1} = (n-1) \times T_E$ und $t_n = n \times T_E$ gemäß einer Abtastperiode $T_E$ einen Abtastwert $U_{n-1+r}$ zu einem fiktiven Abtastzeitpunkt $t_{n-1+r} = (n-1+r) \times T_E$ ergibt, wobei r derart ist, dass $\Delta\varphi = 2\pi r$, und

die Phasenanpassung $\Delta\varphi'$ durch Interpolation angewandt wird, wobei die Interpolation zwischen zwei aufeinander folgenden Strommessungsabtastwerten $I_{n-1}$ und $I_n$ zu den jeweiligen Zeitpunkten $t_{n-1} = (n-1) \times T_E$ und

$t_n = n \times T_E$ einen Abtastwert $I_{n-1+r'}$ zu einem fiktiven Abtastzeitpunkt $t_{n-1+r'} = (n-1+r') \times T_E$ ergibt, wobei r' dergestalt ist, dass $\Delta\varphi'=2\pi r'$.

3. Verfahren nach Anspruch 2, wobei die Interpolation linear ist, wobei die lineare Interpolation interpolierte Spannungs-abtastwerte $U_{n-1+r}$ und interpolierte Stromabtastwerte $I_{n-1+r'}$ ergibt, so dass:

$$U_{n-1+r} = (1+ K_U) \times (r \times U_n + (1-r) \times U_{n-1})$$

und

$$I_{n-1+r'} = (1+ K_I) \times (r' \times I_n + (1-r') \times I_{n-1}) + K'_I \times U_{n-1+r}.$$

4. Verfahren nach einem der Ansprüche 1 bis 3, wobei die elektrische Anlage, die von dem elektrischen Zähler überwacht wird, dreiphasig versorgt wird.

5. Verfahren nach einem der Ansprüche 1 bis 4, wobei die mindestens eine Leistungsberechnung eine Wirkleistungs-und/oder Blindleistungs- und/oder Scheinleistungsberechnung ist.

6. Computerprogrammprodukt, das Programmcodeanweisungen umfasst, die bei der Ausführung der Anweisungen durch einen Prozessor eines Controllers (500) eines elektrischen Zählers eine Implementierung des Verfahrens nach einem der Ansprüche 1 bis 5 bewirken.

7. Informationsspeichermedium, das Programmcodeanweisungen speichert, die beim Lesen und Ausführen der Anweisungen durch einen Prozessor eines Controllers (500) eines elektrischen Zählers zu einer Implementierung des Verfahrens nach einem der Ansprüche 1 bis 5 führen.

8. Controller (500) eines elektrischen Zählers, der dazu ausgestaltet ist, einen elektrischen Verbrauch einer elektrischen Anlage zu ermitteln, die durch mindestens eine Phase elektrisch versorgt wird und die von dem elektrischen Zähler überwacht wird, wobei der Controller (500) elektronische Schaltkreise umfasst, die ausgestaltet sind zum:

   - Erhalten (601, 603), für jede Phase, von Spannungsmessungsabtastwerten und von Strommessungsabtastwerten;
   - Anwenden (602) einer Amplitudenanpassung $K_U$ und einer Phasenanpassung $\Delta\varphi$ auf die Spannungsmes-sungsabtastwerte, um angepasste Spannungsabtastwerte zu erhalten;
   - Anwenden (604) einer Amplitudenanpassung $K_I$ und einer Phasenanpassung $\Delta\varphi'$ auf die Strommessungs-abtastwerte, um angepasste Stromabtastwerte zu erhalten;
   - Durchführen (605) mindestens einer Leistungsberechnung ausgehend von den angepassten Spannungs- und Stromabtastwerten; und
   - Ermitteln (606) des elektrischen Verbrauchs ausgehend von der mindestens einen Leistungsberechnung, **dadurch gekennzeichnet, dass** die elektronischen Schaltkreise zum Erhalten der angepassten Stromabtastwerte ferner ausgestaltet sind zum:

      - Anwenden einer ergänzenden Anpassung auf die Strommessungsabtastwerte, um eine Spannungsmessungsabtastwertespreizung bei den Strommessungsabtastwerten zu kompensieren, wobei die ergänzende Anpassung eine Anwendung einer Verstärkung $K'_I$ auf entsprechende angepasste Spannungsabtastwerte ist.

9. Elektrischer Zähler, der einen Controller (500) nach Anspruch 8 umfasst.

**Claims**

1. Method for establishing an electrical consumption of an electrical installation that is electrically supplied by at least one phase and is monitored by an electricity meter, the method being implemented by a controller (500) of the electricity meter and comprising:

- obtaining (601, 603), for each phase, samples of voltage measurements and samples of current measurements;
- applying (602) an amplitude adjustment $K_U$ and a phase adjustment $\Delta\varphi$ to the voltage measurement samples to obtain adjusted voltage samples;
- applying (604) an amplitude adjustment $K_I$ and a phase adjustment $\Delta\varphi'$ to the current measurement samples to obtain adjusted current samples;
- making (605) at least one power calculation from the adjusted voltage and current samples; and
- establishing (606) the electrical consumption from said at least one power calculation, **characterised in that** the method further comprises, for obtaining the adjusted current samples:

- applying a supplementary adjustment to the current measurement samples to compensate for a spreading of voltage measurement samples with respect to the current measurement samples, the supplementary adjustment being an application of gain $K'_I$ to said corresponding adjusted voltage samples.

2. Method according to claim 1, wherein the phase adjustment $\Delta\varphi$ is applied by interpolation, where, between two successive voltage measurement samples $U_{n-1}$ and $U_n$ at respective instants $i_{n-1} = (n-1) \times T_E$ and $t_n = n \times T_E$ in accordance with a sampling period $T_E$, the interpolation supplies a sample $U_{n-1+r}$ at a fictitious sampling instant $t_{n-1+r} = (n-1+r) \times T_E$, with $r$ such that $\Delta\varphi = 2\pi r$, and

the phase adjustment $\Delta\varphi'$ is applied by interpolation, where, between two successive current measurement samples $I_{n-1}$ and $I_n$ at the respective instants $t_{n-1} = (n-1) \times T_E$ and $t_n = n \times T_E$, the interpolation supplies a sample $I_{n-1+r'}$ at a fictitious sampling instant $t_{n-1+r'} = (n-1+r') \times T_E$, with $r'$ such that $\Delta\varphi' = 2\pi r'$.

3. Method according to claim 2, wherein the interpolation is linear, where the linear interpolation provides interpolated voltage samples $U_{n-1+r}$ and interpolated current samples $I_{n-1+r}$ such that:

$$U_{n-1+r} = (1 + K_U) \times (r \times U_n + (1-r) \times U_{n-1})$$

and

$$I_{n-1+r'} = (1 + K_I) \times (r' \times I_n + (1-r') \times I_{n-1}) + K'_I \times U_{n-1+r}.$$

4. Method according to any one of claims 1 to 3, wherein the electrical installation that is monitored by the electricity meter is supplied in three phase.

5. Method according to any one of claims 1 to 4, wherein said at least one power calculation is an active power and/or reactive power and/or apparent power calculation.

6. Computer program product comprising program code instructions causing an implementation of the method according to any one of claims 1 to 5, when said instructions are executed by a processor of an electricity-meter controller (500).

7. Information storage medium storing program code instructions causing an implementation of the method according to any one of claims 1 to 5, when said instructions are read and executed by a processor of an electricity-meter controller (500).

8. Electricity-meter controller (500) that is configured to establish an electrical consumption of an electrical installation that is electrically supplied by at least one phase and is monitored by the electricity meter, said controller (500) comprising electronic circuitry configured for:

- obtaining (601, 603), for each phase, samples of voltage measurements and samples of current measurements;
- applying (602) an amplitude adjustment $K_U$ and a phase adjustment $\Delta\varphi$ to the voltage measurement samples to obtain adjusted voltage samples;
- applying (604) an amplitude adjustment $K_I$ and a phase adjustment $\Delta\varphi'$ to the current measurement samples to obtain adjusted current samples;
- making (605) at least one power calculation from the adjusted voltage and current samples; and
- establishing (606) the electrical consumption from said at least one power calculation, **characterised in that** the electronic circuitry is furthermore configured, in order to obtain the adjusted current samples, to:

- apply a supplementary adjustment to the current measurement samples to compensate for a spreading of voltage measurement samples with respect to the current measurement samples, the supplementary adjustment being an application of gain $K'_l$ to said corresponding adjusted voltage samples.

9. Electricity meter comprising a controller (500) according to claim 8.

Fig. 1

Fig. 2

**Fig. 3**

**Fig. 4**

**Fig. 5**

Obtenir des échantillons de mesure de tension — 601

Effectuer un ajustement en phase et en amplitude des échantillons de mesure de tension obtenus — 602

Obtenir des échantillons de mesure de courant — 603

Effectuer un ajustement en phase et en amplitude des échantillons de mesure de courant obtenus — 604

Effectuer au moins un calcul de puissance, à partir des échantillons de mesure de tension et de courant ajustés — 605

Etablir une consommation électrique d'après le calcul de puissance — 606

**Fig. 6**

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030088374 A1

- US 2022413023 A1